(19) Europäisches Patentamt
European Patent Office
Office européen des brevets

(11) **EP 3 011 071 B1**

(12) **FASCICULE DE BREVET EUROPEEN**

(45) Date de publication et mention de la délivrance du brevet:
**22.11.2017  Bulletin 2017/47**

(51) Int Cl.:
*C23C 14/06* [(2006.01)]   *C23C 14/34* [(2006.01)]
*H01M 4/04* [(2006.01)]

(21) Numéro de dépôt: **14735617.4**

(22) Date de dépôt: **12.06.2014**

(86) Numéro de dépôt international:
**PCT/FR2014/051448**

(87) Numéro de publication internationale:
**WO 2014/202875 (24.12.2014 Gazette 2014/52)**

(54) **PROCÉDÉ DE PRÉPARATION D'UN FILM AMORPHE A BASE DE SULFURE OU D'OXYSULFURE MÉTALLIQUE LITHIE**

VERFAHREN ZUR HERSTELLUNG EINES AMORPHEN FILMS AUS LITHIIERTEM METALLSULFID ODER OXYSULFID

METHOD FOR PREPARING AN AMORPHOUS FILM MADE FROM LITHIATED METAL SULFIDE OR OXYSULFIDE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **20.06.2013  FR 1355882**

(43) Date de publication de la demande:
**27.04.2016  Bulletin 2016/17**

(73) Titulaires:
• **Commissariat à l'Énergie Atomique et aux Énergies Alternatives**
  **75015 Paris (FR)**
• **Centre National de la Recherche Scientifique (C.N.R.S.)**
  **75016 Paris (FR)**
• **Institut Polytechnique de Bordeaux**
  **33400 Talence (FR)**

(72) Inventeurs:
• **LE CRAS, Frédéric**
  **33140 Villenave D'ornon (FR)**
• **DUBOIS, Vincent**
  **33100 Bordeaux (FR)**
• **GUY-BOUYSSOU, Delphine**
  **37230 Luynes (FR)**

• **PECQUENARD, Brigitte**
  **33140 Villenave D'ornon (FR)**

(74) Mandataire: **Cabinet Laurent & Charras**
  **Le Contemporain**
  **50 Chemin de la Bruyère**
  **69574 Dardilly Cedex (FR)**

(56) Documents cités:
  **US-A1- 2007 172 738     US-A1- 2011 076 567**

• **PARK S H ET AL: "Synthesis and electrochemical properties of lithium nickel oxysulfide (LiNiSyO2-y) material for lithium secondary batteries", ELECTROCHIMICA ACTA, ELSEVIER SCIENCE PUBLISHERS, BARKING, GB, vol. 47, no. 11, 20 mars 2002 (2002-03-20) , pages 1721-1726, XP004343888, ISSN: 0013-4686, DOI: 10.1016/S0013-4686(02)00023-3**
• **JOO K -H ET AL: "Lithium ion conducting lithium sulfur oxynitride thin film", ELECTROCHEMICAL AND SOLID-STATE LETTERS ELECTROCHEM. SOC. USA, vol. 7, no. 8, 12 juillet 2004 (2004-07-12), pages A256-A258, XP002721034, ISSN: 1099-0062, DOI: 10.1149/1.1769317**

EP 3 011 071 B1

**Description**

**DOMAINE DE L'INVENTION**

L'invention concerne un procédé de préparation d'un film amorphe à base de sulfure ou d'oxysulfure métallique lithié, à partir d'un matériau cible lithié.

Le domaine d'utilisation de la présente invention comprend notamment la préparation d'électrodes pour micro-accumulateurs au lithium.

**ETAT ANTERIEUR DE LA TECHNIQUE**

De manière générale, un accumulateur comprend un empilement des éléments suivants :

- un premier collecteur de courant ;
- une électrode positive ;
- un électrolyte ;
- une électrode négative ;
- un deuxième collecteur de courant.

Les micro-accumulateurs sont constitués de film minces et présentent une épaisseur micrométrique, l'épaisseur totale de ces éléments ne dépassant pas généralement 15 micromètres.

Parmi les micro-accumulateurs au lithium, on peut distinguer les micro-accumulateurs « tout solide », dont l'électrolyte se présente sous forme solide.

S'agissant de la préparation des constituants d'un accumulateur (électrodes, électrolyte solide), les techniques de dépôt sous vide sont particulièrement adaptées, et notamment la pulvérisation cathodique d'un matériau de cible spécifique.

Les matériaux d'électrodes pouvant être utilisés dans ces accumulateurs incluent les composés de type $TiO_yS_x$, eu égard à leur potentiel d'insertion/désinsertion du lithium (1-2.5 $V/Li^+/Li$) et à leur aptitude à pouvoir insérer réversiblement du lithium.

Ils peuvent notamment permettre la réalisation d'un accumulateur de type lithium métal/électrolyte solide/TiOS.

Toutefois, la température de fusion du lithium (180 °C) restreint l'utilisation de ce type de micro-accumulateurs, en raison des températures atteintes lors des opérations de soudure/scellage (de l'ordre de 260 °C).

Par conséquent, de nouvelles configurations d'accumulateurs ont été développées, et notamment :

- les accumulateurs lithium-ion, $Li_xTiO_yS_z$/électrolyte solide/matériau actif d'électrode négative, dans lesquels le matériau d'électrode négative permet d'insérer électro-chimiquement le lithium, et ce à bas potentiel et de manière réversible. Ce matériau thermiquement stable jusqu'à au moins 300 °C peut être un composé tel que par exemple Si, Ge, Al, ou Ag ;
- les accumulateurs dits « lithium free », $LiCoO_2$/électrolyte solide/collecteur de courant, dans lesquels l'électrode négative de lithium est générée in situ sur le collecteur de courant lors de la première charge de l'accumulateur, ce lithium étant initialement présent dans l'électrode positive. Le collecteur de courant peut être choisi parmi les métaux ne formant pas d'alliage avec le lithium, tels que par exemple le titane, le cuivre ou le tungstène.

Dans ces deux configurations, le lithium est incorporé dans l'électrode positive lors de la fabrication du micro-accumulateur. Par exemple, la préparation d'un matériau d'électrode lithié tel que $Li_xTiO_yS_z$, comprend les étapes suivantes :

- dépôt d'un film d'oxysulfure de titane $TiO_yS_z$ sur un substrat, notamment par pulvérisation cathodique. Ce dépôt est réalisé à partir d'une cible de titane, et sous pression partielle d'$H_2S$ ou bien à partir d'une cible de sulfure de titane sous atmosphère d'argon pur ;
- dépôt de lithium sur le film ainsi obtenu, notamment par évaporation thermique de lithium métallique sous vide partiel.

La finalisation et l'homogénéisation du film de $TiO_yS_z$ par diffusion du lithium nécessitent quelques heures, avant tout dépôt ultérieur d'une couche supplémentaire ou, le cas échéant, d'un électrolyte.

Ce procédé implique donc deux dépôts distincts (couche à base de titane, puis couche lithiée), ainsi qu'une étape d'homogénéisation de la couche formée par diffusion du lithium.

Par conséquent, la composition et l'homogénéité des couches successives peuvent varier d'un échantillon à l'autre. D'autre part, la régularité des propriétés des films peut s'avérer problématique.

En outre, les étapes de préparation du film de $TiO_yS_z$ et d'évaporation du lithium n'étant pas réalisées dans une même enceinte, ce procédé requiert un transfert du matériau $TiO_yS_z$ qui est hygroscopique, augmentant ainsi les risques de détérioration.

Le document US 2011/0076567 décrit la préparation d'une cathode par dépôt physique en phase vapeur de LiTiOS. Park et al. (Electrochimica Acta, 2002, vol 47, pages 1721-1726) ont décrit la synthèse d'un matériau de type $LiNiS_yO_{2-y}$, par exemple $LiNiO_{1,9}S_{0,1}$ ($Li_1Ni_1(O_{1-0,05}S_{0,05})_2$) ou $LiNiO_{1,7}S_{0,3}(Li_1Ni_1(O_{1-0,0,15}S_{0,15})_2$. Ces documents ne décrivent pas de procédé de formation d'un film à partir d'un matériau cible lithié.

Joo et al. (Electrochemical and solid-state letters, 2004, 7 (8) A256-A258) décrivent des films d'oxysulfure de lithium et leur préparation. Le seul métal contenu dans ces films est le lithium.

Le Demandeur a mis au point un procédé permettant de remédier à ces écueils. En mettant en oeuvre une seule étape, ce procédé ne nécessite pas de transfert de matériau.

D'autre part, le procédé - objet de l'invention, ne comprend pas d'étape de diffusion du lithium. Il ne met pas en oeuvre de sulfure d'hydrogène et de lithium métallique, composés dont les réactivités respectives rendent la manipulation délicate.

Le procédé objet de l'invention optimise la préparation de films homogènes amorphes de type $Li_x-MO_yS_z$ à partir d'un matériau cible.

## EXPOSE DE L'INVENTION

L'objet de l'invention concerne un procédé de préparation de films amorphes de sulfures ou d'oxysulfures métalliques lithiés, à partir d'un matériau cible lithié.

Contrairement aux procédés de l'art antérieur impliquant de multiples étapes de dépôt, évaporation, et diffusion pendant plusieurs heures, le procédé - objet de l'invention nécessite une seule étape de dépôt d'un film de composition homogène.

Par film ou film mince, on entend un dépôt d'au moins une couche d'un matériau. L'épaisseur totale du film est généralement inférieure à 10 micromètres.

En outre, par film amorphe de sulfure métallique lithié, on entend également un film comprenant des oxysulfures.

Plus précisément, l'objet de l'invention concerne un procédé de préparation d'un film amorphe de sulfure ou d'oxysulfure métallique lithié de formule $Li_\alpha M(O_{1-\beta}S_\beta)_\gamma$ par mise en oeuvre d'un matériau cible lithié.

Dans la formule $Li_\alpha M(O_{1-\beta}S_\beta)_\gamma$, M est un métal avantageusement choisi dans le groupe comprenant Al, Ti, V, Cr, Mn, Fe, Co, Ni, Cu, Zn, Ge, Zr, Nb, Mo, Ag, Cd, In, Sn, Sb, Ta, W, Pb, Bi, et leurs mélanges ; et

$$\alpha \geq 0,5 \ ;$$

$$1 \geq \beta \geq 2/3 \ ;$$

$$2 \geq \alpha/\gamma \geq 1/3.$$

Le métal M est avantageusement le titane.

La présence simultanée dans le matériau de lithium et de soufre (notamment sous forme d'ions sulfure $S^{2-}$) permet de réaliser conjointement la désinsertion d'ions lithium et l'oxydation des ions à base de soufre, notamment dans le cadre d'utilisation du film en tant que matériau d'électrode positive dans un accumulateur ou micro-accumulateur au lithium, de préférence un micro-accumulateur Li-ion. Ainsi, lorsque le rapport S/O est au moins supérieur à 2 et le rapport Li/(S+O) supérieur à 1/3, la capacité de l'électrode est améliorée.

Contrairement aux matériaux de cible mis en oeuvre dans les procédés de l'art antérieur, le matériau de cible est un matériau lithié. De manière générale, le matériau cible comprend au moins un métal M, du soufre, et du lithium. Il est avantageusement de formule $Li_\lambda M(O_{1-\delta}S_\delta)_\nu$ dans laquelle :

$$\lambda \geq 0,5 \ ;$$

$$1 \geq \delta \geq 2/3 \ ;$$

$$2 \geq \lambda/\nu \geq 1/3.$$

Par matériau cible, on entend une composition de cible correspondant à une composition globale moyenne. En effet, le matériau de cible peut être constitué d'un ou de plusieurs matériaux (polyphasé).

Le métal M du matériau lithié est bien entendu le même que celui du film amorphe.

Le matériau de cible peut notamment être de formule $LiTiS_2$ lorsque M=Ti, $\lambda$=1, $\delta$=1, $\nu$=2.

Les coefficients des formules générales du film et du matériau cible lithié sont généralement distincts. En effet, eu égard aux conditions expérimentales et à l'éventuelle présence d'oxygène, la composition chimique du film obtenu peut varier par rapport à celle du matériau cible. Toutefois, et selon un mode de réalisation particulier, les formules respectives du matériau cible lithié et du film amorphe peuvent être identiques.

La préparation de ce film amorphe est avantageusement réalisée par dépôt du matériau cible lithié sur un substrat. Ce dépôt peut notamment être réalisé par :

- pulvérisation cathodique du matériau de cible lithiée et techniques associées, par exemple par IBAD de l'anglais *« Ion-Beam Assisted Deposition »,* ou par *« ion plating »*) ;
- évaporation du matériau de cible lithiée, par exemple par RPAE de l'anglais *« Reactive Plasma Assisted évaporation »,* ou par évaporation par faisceau d'électron ; ou
- ablation laser du matériau de cible lithiée, par exemple par PLD de l'anglais *« Pulsed Laser Deposition ».*

La technique de pulvérisation cathodique est généralement réalisée dans un réacteur ou une enceinte. Un matériau cible est fixé sur un support métallique faisant office de cathode. La cathode est ensuite polarisée négativement à l'aide d'un générateur électrique. Sous l'effet du champ électrique, le gaz de décharge contenu dans l'enceinte (hélium, néon, argon ou krypton par exemple) est ionisé. Les ions positifs du gaz ionisé bombardent alors la cible et éjectent des atomes de la cible.

Ces atomes se redéposent ensuite sur la surface opposée où est placé un substrat à recouvrir, placé généralement à une distance comprise entre 5 et 12 cm. Ainsi, cette technique permet le dépôt d'une couche/film mince de matériau sur un substrat.

L'ablation est une technique de dépôt consistant principalement à réaliser des impulsions laser sur un matériau cible. Ces impulsions laser (laser pulsé UV) permettent d'arracher des atomes du matériau cible. Les atomes se déposent ensuite sur la surface d'un substrat, de manière à former ainsi une couche/film mince de matériau.

Dans le cadre de l'invention, le substrat est avantageusement conducteur électronique. Il s'agit préférentiellement d'un collecteur de courant lorsque le film déposé est destiné à être utilisé en tant que matériau d'électrode. Ce collecteur de courant est avantageusement métallique.

Comme déjà indiqué, le dépôt par pulvérisation cathodique est avantageusement réalisé sous atmosphère inerte, de préférence sous argon. Toutefois, selon un mode de réalisation particulier, elle peut être réalisée dans une enceinte de dépôt en présence d'oxygène. L'oxygène introduit peut notamment se présenter sous forme d'oxygène moléculaire ou atomique, d'oxyde métallique, ou d'oxysulfure métallique présent dans le matériau cible. Il peut également résulter de la présence d'humidité.

La composition du film amorphe de formule $Li_\alpha M(O_{1-\beta}S_\beta)_\gamma$ dépend ainsi de la concentration en oxygène dans l'enceinte de dépôt dans laquelle est mis en oeuvre le procédé selon l'invention, que l'oxygène soit introduit volontairement ou non.

Cette concentration peut être exprimée en pression partielle d'oxygène (typiquement inférieure à 10%) dans l'enceinte de dépôt, elle-même à une certaine pression totale (typiquement comprise entre 0,2 et 2,5 Pa pour la pulvérisation cathodique). L'homme métier saura adapter la quantité d'oxygène et la pression en fonction du matériau cible utilisé et du film amorphe souhaité. En effet, la pression au sein de l'enceinte de dépôt peut varier selon la technique mise en oeuvre. Elle est typiquement de l'ordre de $10^{-5}$ à 50 Pa pour l'ablation laser.

L'oxygène permet ainsi de former des oxysulfures dont la présence modifie les états d'oxydation du soufre, et donc les propriétés électrochimiques du matériau lithié ainsi obtenu.
La composition chimique, et notamment la stoechiométrie, du film obtenu par le procédé de l'invention dépend du matériau cible mis en oeuvre, mais également de la présence d'oxygène.

Selon un autre mode de réalisation particulier mettant en oeuvre la technique de pulvérisation cathodique, le procédé peut comprendre une étape initiale de pulvérisation d'un métal (par exemple du titane) sur un cache. Cette étape permet de limiter les traces éventuelles d'oxygène et d'humidité. Ce n'est qu'ensuite que le matériau cible est pulvérisé, éventuellement après avoir introduit dans l'enceinte une quantité connue d'oxygène.

Cette étape permet de mieux contrôler la reproductibilité des films.

Le film amorphe qui est avantageusement de formule $Li_\alpha M(O_{1-\beta}S_\beta)_\gamma$ est obtenu par dépôt du matériau de cible lithié qui peut se présenter sous forme de poudre cristallisée compactée ou frittée.

Le matériau de cible, notamment lorsqu'il est constitué d'un seul composé, possède les propriétés nécessaires aux électrodes d'un accumulateur au lithium, à savoir l'aptitude à extraire électro-chimiquement le lithium, tout en oxydant simultanément les ions métalliques et/ou les ions sulfures (y compris les polysulfures).

Il peut être avantageusement synthétisé, préalablement à sa mise en oeuvre, selon au moins les deux modes de réalisation suivants :

- par voie liquide, notamment par lithiation d'un matériau précurseur de formule $MS_y$ (y dépend du degré d'oxydation du métal). Il peut s'agir de la lithiation chimique d'une poudre de composition $MS_y$ (par exemple $TiS_2$, $TiS_3$) par utilisation d'un composé de lithium à propriétés réductrices, tel le n-butyllithium. Dans ce cas, le métal et/ou le soufre sont réduits directement lors de l'incorporation du lithium.
ou

- par voie solide, notamment par réaction entre un matériau précurseur de formule $MS_w$ (ou un mélange de précurseurs de ce type) et du sulfure de lithium et éventuellement le métal M correspondant (w dépend du degré d'oxydation du métal) et/ou du soufre élémentaire. Il peut s'agir de la réaction à l'état solide d'un mélange de poudres constitué de : a $Li_2S$ + b $MS_w$ + c M (par exemple 1/2 $Li_2S$ + 3/4 $TiS_2$ + 1/4 Ti → $LiTiS_2$). Ce mélange est soumis à un traitement thermique afin d'assurer la formation du matériau cible (selon un mode de réalisation particulier, le matériau précurseur $MS_w$ peut lui-même être préparé par réaction du métal M avec du soufre élémentaire. Cette réaction peut éventuellement être réalisée in situ lors de la fabrication de la cible).

Le matériau de cible ainsi obtenu sous forme d'une poudre, est ensuite compacté et mis en forme sous pression selon les techniques conventionnelles (pressage uniaxial et pressage isostatique par exemple).

De manière générale, le métal M est avantageusement le titane.

Dans le but d'améliorer la compacité et la tenue mécanique du matériau, et ce quel que soit son mode d'obtention, il est avantageusement soumis à un traitement thermique :

- soit in situ lors de sa mise en forme, par exemple par pressage isostatique à chaud ou par frittage SPS (« *Spark Plasma Sintering* ») ;
- soit ex situ dans un four sous atmosphère inerte.

L'obtention d'une cible dense sera toujours recherchée pour garantir à la fois sa tenue mécanique, minimiser sa réactivité à l'atmosphère lors de sa manipulation après fabrication, et assurer une vitesse de dépôt maximale.

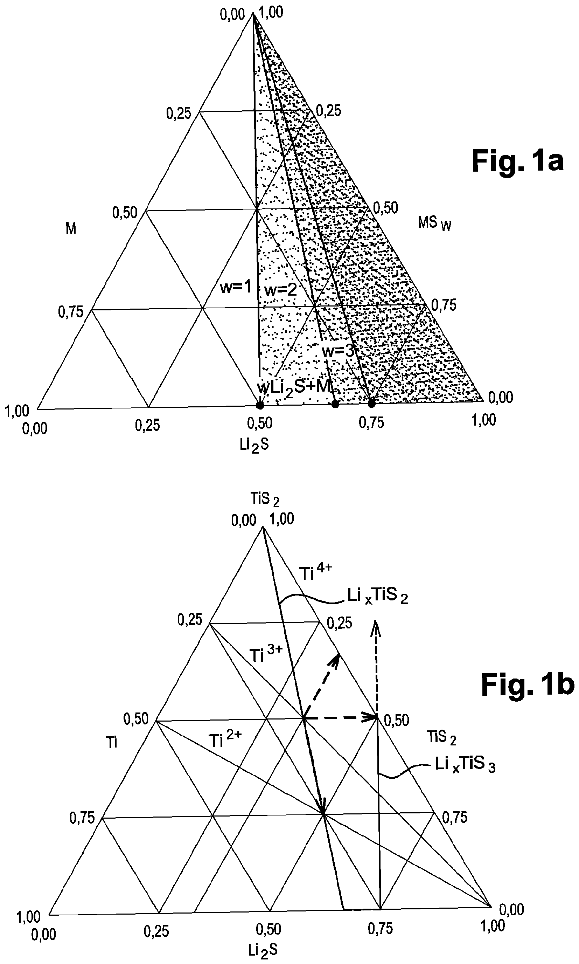

Si l'on considère le diagramme ternaire $Li_2S$-$MS_w$-$M$ de la figure 1a, la composition du matériau cible peut avantageusement correspondre au triangle défini par les sommets $Li_2S$-$MS_w$-$(wLi_2S+M)$, la droite $MS_w$-$(wLi_2S+M)$ correspondant à l'insertion du lithium dans $MS_w$. Le composé $MS_w$ correspond à un sulfure métallique, le facteur $w$ dépendant du degré d'oxydation du métal et du type d'anions soufrés $S_n^{2-}$ ($n$=1, 2,...).

Le composé précurseur de formule $MS_w$ (ou $MS_y$) peut notamment être choisi dans le groupe comprenant :

- les composés de titane $Ti_8S_9$, $Ti_8S_{10}$, $Ti_{16}S_{21}$, $TiS_2$, $TiS_3$ ;
- les composés de vanadium $V_3S_4$, $V_5S_8$ ;
- les composés de chrome $Cr_{1-\varepsilon}S$, $Cr_2S_3$ ;
- les composés de manganèse $Mn_{1-\varepsilon}S$ ;
- les composés de fer $Fe_{1-\varepsilon}S$, $Fe_3S_4$, $FeS_2$ ;
- les composés de cobalt $C_{09}S_8$, $Co_{1-\varepsilon}S$, $Co_3S_4$, $CoS_2$ ;
- les composés de nickel $Ni_3S_2$, $Ni_9S_8$, $Ni_{1-\varepsilon}S$, $Ni_3S_4$, $NiS_2$ ;
- les composés de cuivre $Cu_{2-\varepsilon}S$, $CuS$ ;
- le composé de zinc $ZnS$ ;
- le composé d'aluminium $Al_2S_3$ ;
- les composés de germanium $GeS$, $GeS_2$ ;
- les composés de zirconium $ZrS_2$, $ZrS_3$ ;
- les composés de niobium $Nb_{10}S_9$, $NbS$, $Nb_2S_3$, $NbS_2$ ;
- les composés de molybdène $Mo_6S_8$, $Mo_2S_3$, $MoS_2$, $MoS_3$ ;
- le composé d'argent $Ag_2S$ ;
- le compose de cadmium $CdS$ ;
- le composé d'indium $In_2S_3$ ;
- les composés d'étain $SnS$, $SnS_2$ ;
- les composés d'antimoine $Sb_2S_3$, $Sb_2S_5$ ;
- le composé de tantale $TaS_2$ ;
- le composé de tungstène $WS_2$ ;
- le composé de plomb $PbS$ ;
- le composé de bismuth $Bi_2S_3$ ;
- et leurs mélanges.

Lorsque le métal est le titane, la composition du matériau cible est avantageusement comprise dans le triangle défini par les sommets $Li_2S$-$TiS_2$-$Li_4TiS_2$ du diagramme ternaire de la figure 1b pour $w$ = 2 ou $Li_2S$-$TiS_3$-$Li_6TiS_3$ pour $w$=3.

Le procédé - objet de l'invention permet de préparer des films minces, dont les propriétés électrochimiques sont améliorées par rapport aux matériaux de l'art antérieur.

Les films obtenus peuvent ainsi présenter un pseudo-plateau de potentiel de 2.1 V (correspondant au(x) processus d'oxydo-réduction sur le soufre uniquement), alors que les films post lithiés de l'art antérieur présentent un pseudo-plateau entre 1 et 3 V (redox S et Ti). Toutefois, dans le cadre de l'invention, il est aussi possible de faire travailler le titane à plus bas potentiel, ce qui permet d'augmenter la capacité disponible.

En outre, la capacité volumique du film de l'invention peut être avantageusement comprise entre 40 et 200 microAh/(cm$^2$.$\mu$m) alors que de manière générale, elle n'excède pas 65 microAh/(cm2.$\mu$m) dans le cas des films de $LiCoO_2$ et de $LiMn_2O_4$ de l'art antérieur.

Le rapport S/O influence la capacité volumique du matériau lorsqu'il est utilisé en tant que matériau d'électrode (notamment dans une fenêtre de potentiel centrée autour de 2V/Li$^+$/Li). En outre, le procédé - objet de l'invention, permet d'obtenir un film dense présentant ainsi des propriétés accrues. En effet, la capacité volumique dépend également de l'épaisseur du film qui agit sur la cinétique de conduction (ionique ou électronique) notamment lorsque les courants appliqués sont importants.

Le procédé - objet de l'invention permet de moduler la composition du film en ajustant les proportions respectives des composés précurseurs du matériau cible (par exemple $Li_2S/(M+MS_w)$). Ce procédé permet donc également de moduler les performances du film préparé.

A cet égard, l'augmentation de $Li_2S$ entraine une augmentation de la capacité en raison de la participation accrue du soufre aux processus rédox.

D'autre part, l'augmentation de $(M+MS_w)$ entraine l'amélioration de la tenue en cyclage à fort courant du fait d'une meilleure conductivité électronique.

Le procédé - objet de l'invention permet ainsi un meilleur contrôle de la stoechiométrie des couches déposées par rapport aux procédés de l'art antérieur impliquant une post lithiation.

La présente invention concerne également une électrode comprenant film de sulfure ou d'oxysulfure métallique lithié obtenu selon le procédé décrit ci-avant. Il peut s'agir d'une électrode positive ou négative. Elle est avantageusement positive.

En outre, l'accumulateur, avantageusement un accumulateur ou micro-accumulateur Li-ion, contenant au moins une telle électrode fait également partie de l'invention.

Le procédé de préparation de cet accumulateur Li-ion comprend notamment le dépôt d'une électrode, avantageusement positive, à partir d'un matériau cible lithié, ladite électrode, avantageusement positive, étant constituée d'un film amorphe de sulfure ou d'oxysulfure métallique lithié de formule $Li_\alpha M(O_{1-\beta}S_\beta)_\gamma$.

L'homme du métier saura choisir les matériaux appropriés c'est à dire les matériaux d'électrodes, l'électrolyte (liquide, solide ou gel), les collecteurs de courant, de manière à préparer le (micro)accumulateur au lithium.

L'électrode constituée du film amorphe de l'invention permet la formation d'une interface de bonne qualité avec l'électrolyte eu égard à sa densité accrue et à son état de surface peu rugueux.

L'invention et les avantages qui en découlent ressortiront mieux des figures et exemples suivants donnés afin d'illustrer l'invention, et ce de manière non limitative.

## DESCRIPTION DES FIGURES

La figure 1a représente le diagramme ternaire du matériau cible mis en oeuvre dans le procédé objet de l'invention.

La figure 1b représente le diagramme ternaire du matériau cible mis en oeuvre dans le procédé objet de l'invention, lorsque M est le titane et le précurseur est $TiS_2$.

La figure 2a représente le graphe correspondant à la composition élémentaire déterminée par spectroscopie Auger d'un film de $Li_{0,8}TiO_{0,2}S_{1,8}$ selon l'invention, en fonction de la profondeur.

La figure 2b représente la photographie MEB (microscopie électronique à balayage) de la section d'un film de $Li_{0,8}TiO_{0,2}S_{1,8}$ selon l'invention.

La figure 3a représente la composition élémentaire déterminée par spectroscopie Auger d'un film de $Li_{0,5}TiO_{0,4}S_{1,5}$ selon l'invention, en fonction de la profondeur.

La figure 3b représente la photographie MEB de la section d'un film de $Li_{0,5}TiO_{0,4}S_{1,5}$ selon l'invention.

La figure 4a représente la composition élémentaire déterminée par spectroscopie Auger d'un film de $Li_{1,8}TiO_{0,4}S_{2,5}$ selon l'invention, en fonction de la profondeur

La figure 4b représente la photographie MEB de la section d'un film de $Li_{1,8}TiO_{0,4}S_{2,5}$ selon l'invention.

La figure 5a représente le graphe correspondant au cyclage galvanostatique à différents régimes de courant d'un film $Li_{0,8}TiO_{0,2}S_{1,8}$ selon l'invention.

La figure 5b représente l'évolution de la capacité volumique (échelle de gauche) en fonction du nombre de cycles d'un film $Li_{0,8}TiO_{0,2}S_{1,8}$ selon l'invention. Elle représente également l'efficacité coulombique (échelle de droite) en fonction du nombre de cycles d'un film $Li_{0,8}TiO_{0,2}S_{1,8}$ selon l'invention.

La figure 6a représente le graphe correspondant au cyclage galvanostatique à différents régimes de courant d'un film $Li_{0,5}TiO_{0,4}S_{1,5}$ selon l'invention.

La figure 6b représente l'évolution de la capacité volumique (échelle de gauche) en fonction du nombre de cycles d'un film $Li_{0,5}TiO_{0,4}S_{1,5}$ selon l'invention. Elle représente également l'efficacité coulombique (échelle de droite) en fonction du nombre de cycles d'un film $Li_{0,5}TiO_{0,2}S_{1,5}$ selon l'invention.

La figure 7a représente le graphe correspondant au cyclage à différents régimes de courant d'un film $Li_{1,8}TiO_{0,4}S_{2,5}$ selon l'invention.

La figure 7b représente l'évolution de la capacité volumique (échelle de gauche) en fonction du nombre de cycles d'un film $Li_{1,8}TiO_{0,4}S_{2,5}$ selon l'invention. Elle représente également l'efficacité coulombique (échelle de droite) en fonction du nombre de cycles d'un film $Li_{1,8}TiO_{0,4}S_{2,5}$ selon l'invention.

## EXEMPLES DE REALISATION DE L'INVENTION

Les exemples suivants concernent la mise en oeuvre du procédé - objet de l'invention afin de préparer des films minces de $Li_\alpha M(O_{1-\beta}S_\beta)_\gamma$ et leur utilisation dans un accumulateur au lithium. Trois matériaux de cible ont également été préparés, soit par voie liquide (exemple 1), soit pas voie solide (exemples 1 et 2).

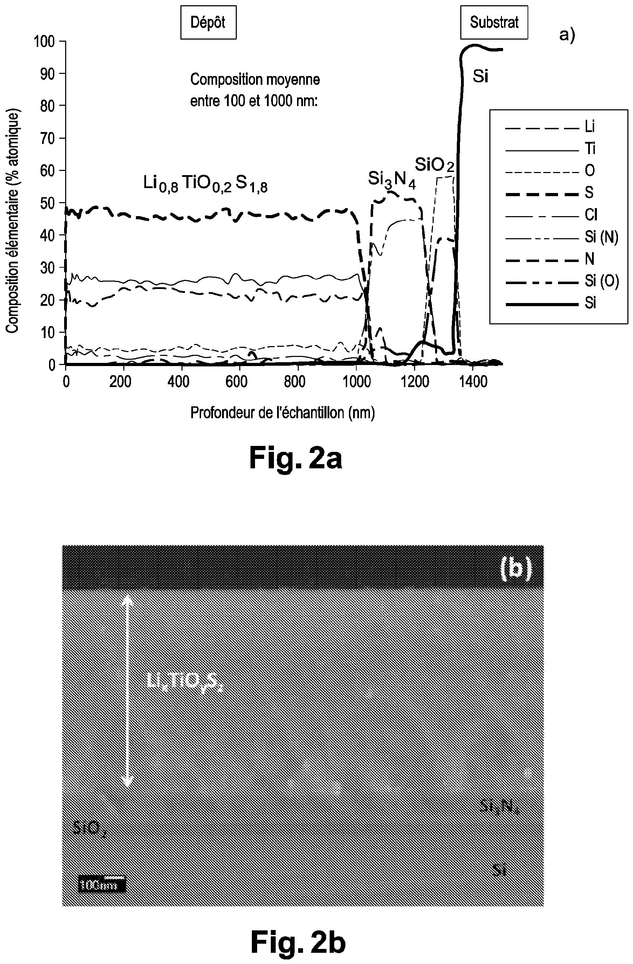

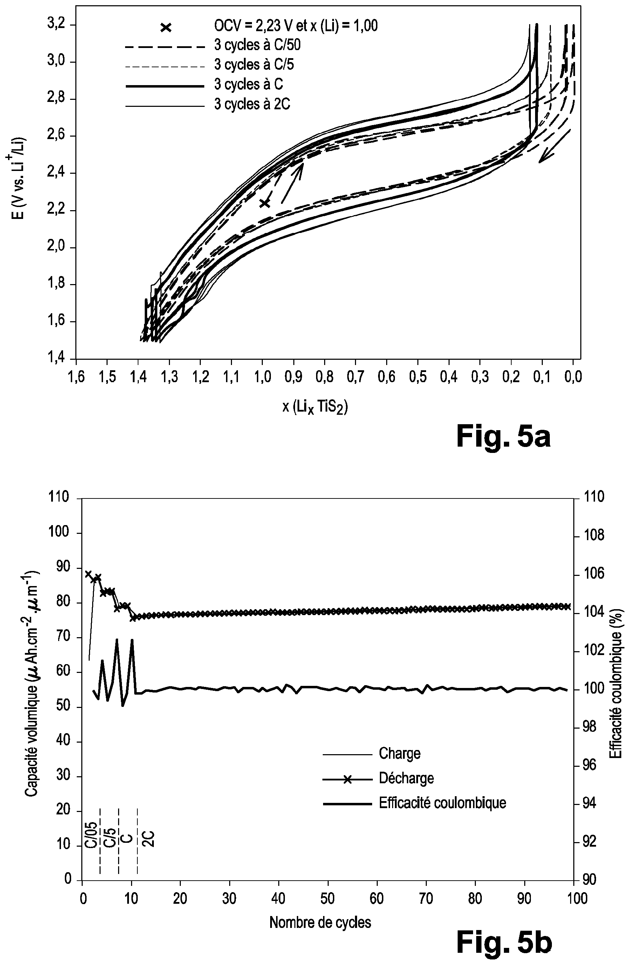

Exemple 1 : Film mince de $Li_{0,8}TiO_{0,2}S_{1,8}$ (Figures 2 et 5)

Le matériau cible $LiTiS_2$ est préparé par voie liquide, sous atmosphère inerte (Ar) en boite à gants, par réaction entre le sulfure de titane $TiS_2$ (de chez Aldrich, 99,9 %) en solution dans de l'hexane anhydre avec le n-butyllithium (de chez Aldrich, à 1,6 M dans de l'hexane). Le mélange est agité à la température ambiante pendant une semaine.

La poudre obtenue est ensuite filtrée, puis lavée à l'hexane, et séchée à température ambiante sous argon.

Environ 15 g du matériau $LiTiS_2$ ainsi obtenu sont pressés dans un moule sous une pression d'environ $6.10^7 N.m^{-2}$ afin d'obtenir une cible de $LiTiS_2$ de 5 centimètres de diamètre et environ 5 millimètres d'épaisseur.

Le matériau cible est ensuite placé dans une enceinte de pulvérisation cathodique radiofréquence à cathode magnétron afin de réaliser un dépôt d'un film mince de $Li_\alpha M(O_{1-\beta}S_\beta)_\gamma$ selon les conditions suivantes :

L'enceinte de pulvérisation de type PLASSYS est connectée à une boite à gants. Elle est équipée de deux cathodes. La cible de $LiTiS_2$ est positionnée sur l'une de ces cathodes alors qu'une cible de Ti commercial (Lesker 99,7 %) est positionnée sur l'autre cathode.

L'enceinte est alors mise sous vide (vide limite inférieur à $5.10^{-7}$ mbar).

Un dépôt initial de titane est réalisé sur un cache pendant 20 minutes afin de piéger, au moins en partie, l'oxygène et l'eau éventuellement présents dans l'enceinte.

Dans cet exemple, de l'oxygène additionnel n'est pas introduit intentionnellement dans l'enceinte de pulvérisation.

Le film mince de $Li_{0,8}TiO_{0,2}S_{1,8}$ est alors réalisé par pulvérisation de la cible $LiTiS_2$ sur un substrat à base de silicium. Le dépôt est effectué pendant 45 minutes, à une pression totale de 0,5 Pa, sous un flux d'argon de 20 mL.min$^{-1}$, et avec une puissance de 25 W appliquée à la cible de $LiTiS_2$.

La vitesse de dépôt est environ de 5 nm.min$^{-1}$ dans ces conditions.

Le film mince amorphe et dense de $Li_{0,8}TiO_{0,2}S_{1,8}$ ainsi obtenu (Figure 2) présente une épaisseur d'environ 600 nanomètres. Ses performances électrochimiques ont été testées en électrolyte liquide et en configuration Li-métal.

La spectroscopie Auger permet d'obtenir un profil de composition en profondeur de manière à étudier l'homogénéité de la couche. Les compositions ont également été déterminées par ICP, RBS et microsonde de Castaing.

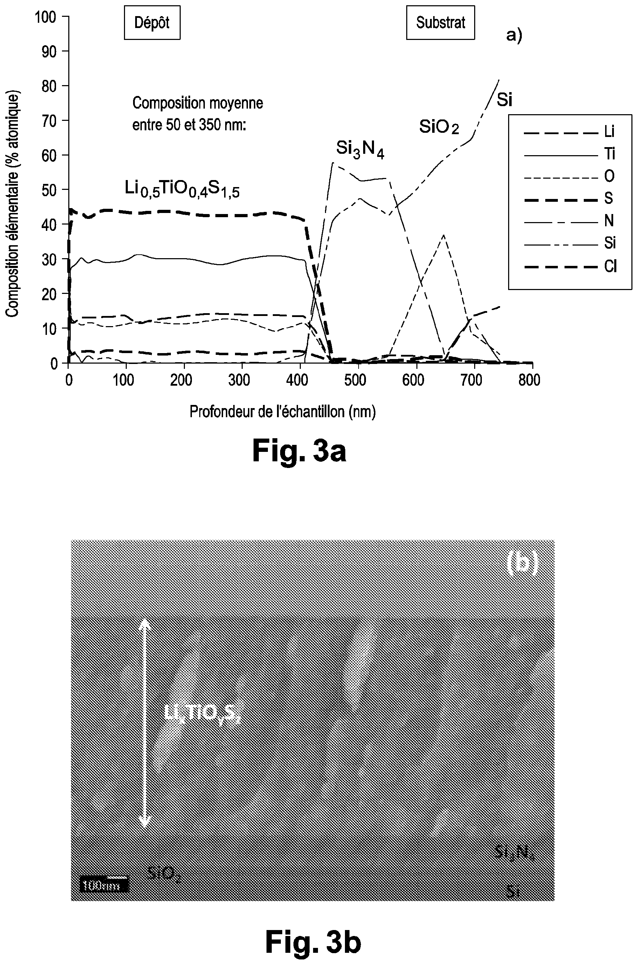

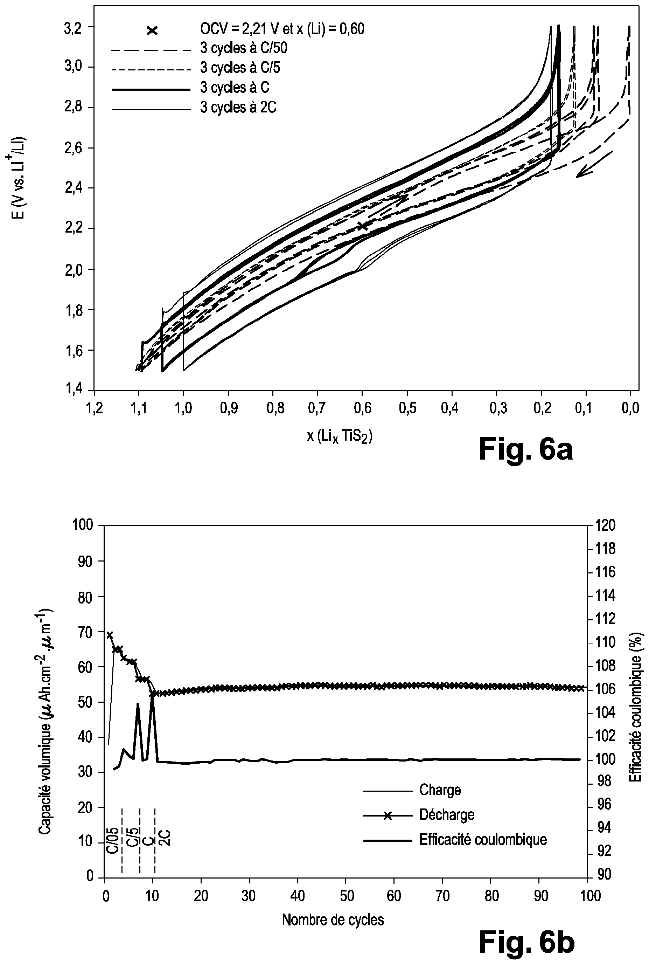

Exemple 2 : Film mince de $Li_{0,5}TiO_{0,4}S_{1,5}$ (Figures 3 et 6)

Le matériau cible LiTiS$_2$ est préparé par voie solide, à partir d'un mélange de TiS$_2$ (Aldrich 99,9 %), Li$_2$S (Alfa Aesar 99,9%) et de Ti (Alfa Aesar 99,99%) en proportions molaires (3/4 : 1/2 : 1/4) permettant d'obtenir la stoechiométrie LiTiS$_2$ désirée.

Environ 15 g du mélange ainsi obtenu sont mélangées sous argon au moyen d'un broyeur planétaire, avant d'être mis en forme dans un moule, et pressés à environ 6. 10$^7$ N.m$^{-2}$ afin d'obtenir une cible de matériau précurseur de 5 centimètres de diamètre et environ 5 millimètres d'épaisseur.

Cette pastille est ensuite soumise à un traitement thermique sous argon, à 425°C pendant 40 heures afin d'obtenir la cible de LiTiS$_2$.

Le film mince de $Li_{0,5}TiO_{0,4}S_{1,5}$ est alors réalisé par pulvérisation de la cible LiTiS$_2$ dans les mêmes conditions que celles de l'exemple 1. Il présente une épaisseur d'environ 700 nanomètres.

Des dépôts amorphes et denses possédant une composition légèrement différente, moins riche en lithium et en soufre, que les dépôts issus de la voie liquide de l'exemple 1 sont obtenus (Figure 3).

Leurs performances électrochimiques testées en électrolyte liquide et en configuration Li-métal sont intéressantes mais demeurent inférieures à celles de leurs homologues de la voie liquide de l'exemple 1.

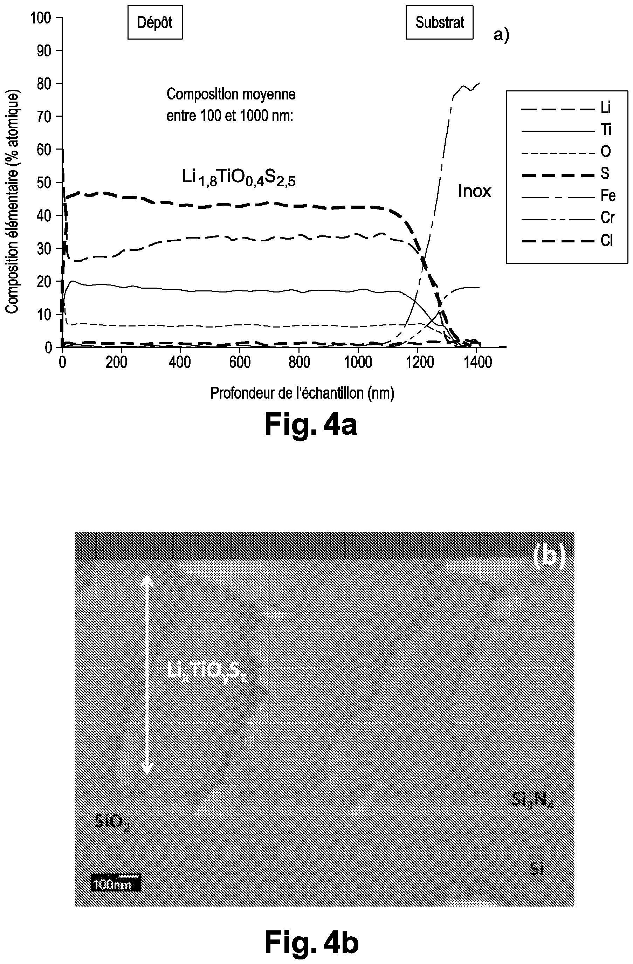

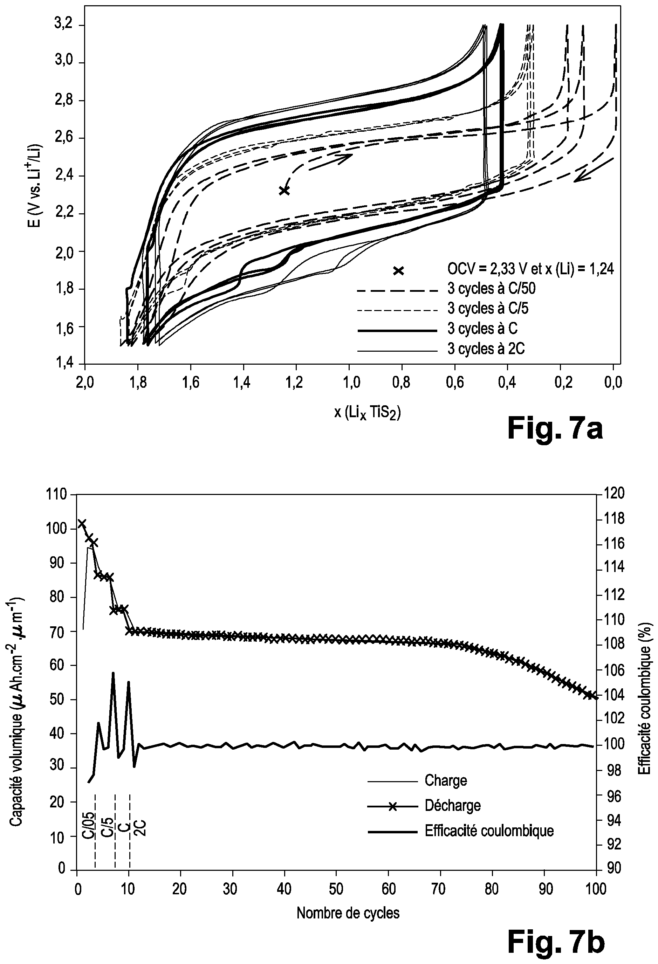

Exemple 3 : Film mince de $Li_{1,8}TiO_{0,4}S_{2,5}$ (Figures 4 et 7)

Un film mince de $Li_\alpha M(O_{1-\beta}S_\beta)_\gamma$ plus riche en lithium et en soufre est préparé en suivant le protocole expérimental de l'exemple 2. Seule la composition de la cible et sa température de synthèse ont été modifiées.

Une cible de stoechiométrie Li$_2$TiS$_3$ est réalisée par voie solide à partir d'un mélange contenant une quantité équimolaire de TiS$_2$ (Aldrich 99,9 %) et de Li$_2$S (Alfa Aesar 99,9 %).

La température de traitement thermique de ce mélange de précurseurs mis sous forme de cible est de 450 °C.

Après dépôt par pulvérisation cathodique dans les mêmes conditions expérimentales que pour les exemples 1 et 2, on obtient un film d'environ 600 nanomètres d'épaisseur, de composition $Li_{1,8}TiO_{0,4}S_{2,5}$ amorphe et dense mais présentant une composition différente des films des exemples 1 et 2 (Figure 4).

Les performances électrochimiques en électrolyte liquide et en configuration Li-métal de ce film sont supérieures en termes de capacité même si leur cyclabilité en électrolyte liquide reste limitée eu égard à la dissolution du soufre dans ce dernier.

COMMENTAIRE GENERAL :

Les figures 5a, 6a, 7a montrent les courbes de cyclage des différents films minces $Li_\alpha Ti(O_{1-\beta}S_\beta)_\gamma$ obtenus. Elles confirment la possibilité d'extraire électro-chimiquement du lithium en première charge (quantité comprise dans ces exemples entre 0.6 et 1.3 Li/Ti suivant la composition des films) et donc de les utiliser comme électrodes positives dans des systèmes électrochimiques lithium-ion.

Les différences dans la forme des courbes entre ces compositions résultent des contributions, spécifiques à chacune des compositions, des processus électrochimiques impliquant le soufre ou le titane. En effet, les processus d'oxydo-réduction liés au soufre se déroulent à plus haut potentiel, et engendrent une hystéréris de potentiel plus élevée, alors que ceux liés au titane interviennent plus bas en potentiel et ne génèrent pas d'hystérésis notable.

Les figures 5b, 6b, 7b montrent que la cyclabilité de ces films et l'efficacité coulombique de la réaction électrochimique sont très bonnes, même à des régimes de courant importants.

Il est également à noter que le cyclage de ces films ayant été réalisé dans un électrolyte liquide, des processus de dégradation liés à la solubilisation progressive d'espèces soufrées interviennent. Ceux-ci expliquent en particulier la perte de capacité plus rapide enregistrée après 70 cycles sur la figure 7b, et la présence d'une 'marche' en fin de certaines décharges sur les courbes figures 5a, 6a, 7a. Ces phénomènes n'ont pas lieu dans une micro-batterie comprenant un électrolyte solide.

**Revendications**

1. Procédé de préparation d'un film amorphe de sulfure ou d'oxysulfure métallique lithié de formule $Li_\alpha Ti(O_{1-\beta}S_\beta)_\gamma$ par mise en oeuvre d'un matériau de cible lithié ; M étant un métal avantageusement choisi dans le groupe comprenant Al, Ti, V, Cr, Mn, Fe, Co, Ni, Cu, Zn, Ge, Zr, Nb, Mo, Ag, Cd, In, Sn, Sb, Ta, W, Pb, Bi, et leurs mélanges ; et

$$\alpha \geq 0,5 ;$$

$$1 \geq \beta \geq 2/3 ;$$

$$2 \geq \alpha/\gamma \geq 1/3$$

**2.** Procédé selon la revendication 1, ***caractérisé* en ce que** le matériau de cible lithié est de formule $Li_\lambda M(O_{1-\delta}S_\delta)_\nu$ dans laquelle :

$$\lambda \geq 0,5 \; ;$$

$$1 \geq \delta \geq 2/3 \; ;$$

$$2 \geq \lambda/\nu \geq 1/3.$$

**3.** Procédé selon la revendication 1 ou 2, ***caractérisé* en ce que** le film amorphe est préparée par mise en oeuvre d'une technique choisie dans le groupe comprenant la pulvérisation cathodique du matériau cible lithié, l'évaporation du matériau cible lithié et l'ablation laser du matériau cible lithié.

**4.** Procédé selon l'une des revendications 1 à 3, ***caractérisé* en ce que** le matériau de cible lithié est préparé, préalablement à sa mise en oeuvre, par voie liquide, par lithiation d'un matériau précurseur de formule $MS_y$.

**5.** Procédé selon la revendication 1 à 3, ***caractérisé* en ce que** le matériau de cible lithié est préparé, préalablement à sa mise en oeuvre, par voie solide, par réaction entre un matériau précurseur de formule $MS_w$ et du sulfure de lithium $Li_2S$, et éventuellement le métal M correspondant et/ou du soufre élémentaire.

**6.** Procédé selon l'une des revendications 1 à 5, ***caractérisé* en ce que** le métal M est le titane.

**7.** Procédé selon la revendication 4 ou 5, ***caractérisé* en ce que** le précurseur de formule $MS_y$ ou $MS_w$ est choisi dans le groupe comprenant les composés de titane $Ti_8S_9$, $Ti_8S_{10}$, $Ti_{16}S_{21}$, $TiS_2$, $TiS_3$ ; les composés de vanadium $V_3S_4$, $V_5S_8$ ; les composés de chrome $Cr_{1-\varepsilon}S$, $Cr_2S_3$ ; les composés de manganèse $Mn_{1-\varepsilon}S$ ; les composés de fer $Fe_{1-\varepsilon}S$, $Fe_3S_4$, $FeS_2$ ; les composés de cobalt $Co_9S_8$, $Co_{1-\varepsilon}S$, $Co_3S_4$, $CoS_2$ ; les composés de nickel $Ni_3S_2$, $Ni_9S_8$, $Ni_{1-\varepsilon}S$, $Ni_3S_4$, $NiS_2$ ; les composés de cuivre $Cu_{2-\varepsilon}S$, $CuS$ ; le composé de zinc $ZnS$ ; le composé d'aluminium $Al_2S_3$ ; les composés de germanium $GeS$, $GeS_2$ ; les composés de zirconium $ZrS_2$, $ZrS_3$ ; les composés de niobium $Nb_{10}S_9$, $NbS$, $Nb_2S_3$, $NbS_2$ ; les composés de molybdène $Mo_6S_8$, $Mo_2S_3$, $MoS_2$, $MoS_3$ ; le composé d'argent $Ag_2S$ ; le compose de cadmium $CdS$ ; le composé d'indium $In_2S_3$ ; les composés d'étain $SnS$, $SnS_2$ ; les composés d'antimoine $Sb_2S_3$, $Sb_2S_5$ ; le composé de tantale $TaS_2$ ; le composé de tungstène $WS_2$ ; le composé de plomb $PbS$ ;

le composé de bismuth $Bi_2S_3$ ; et leurs mélanges.

**8.** Procédé selon la revendication 3, ***caractérisé* en ce qu'**il est réalisé dans une enceinte de dépôt en présence d'oxygène se présentant sous forme d'oxygène moléculaire ou atomique, d'oxyde métallique ou d'oxysulfure métallique présent dans le matériau cible.

**9.** Procédé selon l'une des revendications 1 à 8, ***caractérisé* en ce qu'**il entre dans la formation d'une électrode.

**10.** Procédé selon l'une des revendications 1 à 9, ***caractérisé* en ce qu'**il entre dans la formation d'une électrode pour accumulateur.

**Patentansprüche**

**1.** Verfahren zur Herstellung eines amorphen Films aus lithiiertem Metallsulfid oder -oxysulfid der Formel $Li_\alpha M$ $(O_{1-\beta}S_\beta)_\gamma$ unter Verwendung eines lithiierten Targetmaterials:

wobei M dabei ein Metall ist, das vorteilhafterweise aus der Gruppe Al, Ti, V, Cr, Mn, Fe, Co, Ni, Cu, Zn, Ge, Zr, Nb, Mo, Ag, Cd, In, Sn, Sb, Ta, W, Pb, Bi und Mischungen davonausgewählt wird; und

$$\alpha \geq 0,5;$$

$$1 \geq \beta \geq 2/3;$$

$$2 \geq \alpha / \gamma \geq 1/3.$$

**2.** Verfahren gemäß Anspruch 1 ***dadurch gekennzeichnet, dass*** das lithiierte Targetmaterial die Formel $Li_\lambda M(O_{1-\delta}S_\delta)$ hat, bei der:

$$\lambda \geq 0,5;$$

$$1 \geq \delta \geq 2/3 \; ;$$

$$2 \geq \lambda/\nu \geq 1/3.$$

**3.** Verfahren gemäß Anspruch 1 oder 2, ***dadurch gekennzeichnet, dass*** der amorphe Film durch Einsatz einer Technik hergestellt wird, die aus der Gruppe ausgewählt wird, die die Kathodenzerstäubung des lithiierten Targetmaterials, die Verdampfung des lithiierten Targetmaterials und die Laserablation des lithiierten Targetmaterials umfasst.

4. Verfahren gemäß einem der Ansprüche 1 bis 3 *dadurch gekennzeichnet, dass* das lithiierte Targetmaterials vor dem Einsatz im Nassverfahren durch Lithiierung eines Vorläufermaterials mit der Formel $MS_y$ vorbereitet wird.

5. Verfahren gemäß einem der Ansprüche 1 bis 3, *dadurch gekennzeichnet, dass* das lithiierten Targetmaterials vor dem Einsatz im Feststoffverfahren, durch Reaktion zwischen einem Vorgängermaterial mit der Formel $MS_w$ und Lithiumsulfid $Li_2S$ und eventuell dem entsprechenden Metall M und/oder elementarem Schwefel vorbereitet wird.

6. Verfahren gemäß einem der Ansprüche 1 bis 5, *dadurch gekennzeichnet, dass* es sich bei dem Metall M um Titan handelt.

7. Verfahren gemäß einem der Ansprüche 4 oder 5, **dadurch gekennzeichnet, dass** der Vorläufer mit der Formel $MS_y$ oder $MS_w$ aus der Gruppe ausgewählt wird, die die Titanverbindungen $Ti_8S_9$, $Ti_8S_{10}$ $Ti_8S_9$, $Ti_{16}S_{21}$, $TiS_2$; $TiS_3$, die Vanadiumverbindungen $V_3S_4$, $V_5S_8$; die Chromverbindungen $Cr_{1-\varepsilon}S$, $Cr_2S_3$; die Manganverbindungen $Mn_{1-\varepsilon}S$; die Eisenverbindungen $Fe_{1-\varepsilon}S$, $Fe_3S_4$, $FeS_2$; die Kobaltverbindungen $Co_9S_8$, $Co_{1-\varepsilon}S$, $Co_3S_4$, $CoS_2$; die Nickelverbindungen $Ni_3S_2$, $Ni_9S_8$, $Ni_{1-\varepsilon}S$, $Ni_3S_4$, $NiS_2$; die Kupferverbindungen $Cu_{1-\varepsilon}S$, $CuS$; die Zinkverbindung $ZnS$; die Aluminiumverbindung $Al_2S_3$; die Germaniumverbindungen $GeS$, $GeS_2$ ; die Zirkoniumverbindungen $ZrS_2$, $ZrS_3$; die Niobiumverbindungen $Nb_{10}S_9$, $NbS$, $Nb_2S_3$, $NbS_2$; die Molybdänverbindungen $Mo_6S_8$, $Mo_2S_3$, $MoS_2$, $MoS_3$; die Silberverbindung $Ag_2S$; die Cadmiumverbindung $CdS$; die Indiumverbindung $In_2S_3$; die Zinnverbindungen $SnS$, $SnS_2$; die Antimonverbindungen $Sb_2S_3$, $Sb_2S_5$; die Tantalverbindung $TaS_2$; die Wolframverbindung $WS_2$ ; die Bleiverbindung $PbS$ ; die Bismutverbindung $Bi_2S_3$ ; und ihre Mischungen umfasst.

8. Verfahren gemäß Anspruch 3, *dadurch gekennzeichnet, dass* es in einer Abscheidekammer, in Anwesenheit von im Targetmaterial vorhandenem Sauerstoff in Form molekulares oder atomares Sauerstoffs, Metalloxid oder Metalloxysulfid durchgeführt wird.

9. Verfahren gemäß einem der Ansprüche 1 bis 8, *dadurch gekennzeichnet, dass* es bei der Bildung einer Elektrode eingesetzt wird.

10. Verfahren gemäß einem der Ansprüche 1 bis 9, *dadurch gekennzeichnet, dass* es bei der Bildung einer Elektrode für Akkumulatoren eingesetzt wird.

**Claims**

1. A method of preparing an amorphous film of lithiated metal sulfide or oxysulfide of formula $Li_\alpha M(O_{1-\beta}S_\beta)_\gamma$ by using a lithiated target material:

   M being a metal advantageously selected from the group comprising Al, Ti, V, Cr, Mn, Fe, Co, Ni, Cu, Zn, Ge, Zr, Nb, Mo, Ag, Cd, In, Sn, Sb, Ta, W, Pb, Bi, and mixtures thereof; and

$$\alpha \geq 0.5;$$

$$1 \geq \beta \geq 2/3;$$

$$2 \geq \alpha/\gamma \geq 1/3.$$

2. The method of claim 1, *characterized in that* the lithiated target material has formula $Li_\lambda M(O_{1-\delta}S_\delta)_\nu$ wherein:

$$\lambda \geq 0.5;$$

$$1 \geq \delta \geq 2/3;$$

$$2 \geq \lambda/\nu \geq 1/3.$$

3. The method of claim 1 or 2, *characterized in that* the amorphous film is prepared by implementing a technique selected from the group comprising the cathode sputtering of the lithiated target material, the evaporation of the lithiated target material, and the laser ablation of the lithiated target material.

4. The method of any of claims 1 to 3, *characterized in that* the lithiated target material is prepared, prior to its use, by a liquid process, by lithiation of a precursor material of formula $MS_y$.

5. The method of claim 1 to 3, *characterized in that* the lithiated target material is prepared, prior to its use, by a solid process, by reaction between a precursor material or formula $MS_w$ and lithium sulfide $Li_2S$, and possibly the corresponding metal M and/or elemental sulfur.

6. The method of any of claims 1 to 5, *characterized in that* metal M is titanium.

7. The method of claim 4 or 5, ***characterized in that*** the precursor of formula $MS_y$ or $MS_w$ is selected from the group comprising titanium compounds $Ti_8S_9$, $Ti_8S_{10}$, $Ti_{16}S_{21}$, $TiS_2$, $TiS_3$; vanadium compounds $V_3S_4$, $V_5S_8$; chromium compounds $Cr_{1-\varepsilon}S$, $Cr_2S_3$; manganese compounds $Mn_{1-\varepsilon}S$; iron compounds $Fe_{1-\varepsilon}S$, $Fe_3S_4$, $FeS_2$; cobalt compounds $Co_9S_8$, $Co_{1-\varepsilon}S$, $Co_3S_4$, $CoS_2$; nickel compounds $Ni_3S_2$, $Ni_9S_8$, $Ni_{1-\varepsilon}S$, $Ni_3S_4$, $NiS_2$; copper compounds $Cu_{2-\varepsilon}S$, $CuS$; zinc compound $ZnS$; aluminum compound $Al_2S_3$; germanium compounds $GeS$, $GeS_2$; zirconium compounds $ZrS_2$, $ZrS_3$; niobium compounds $Nb_{10}S_9$, $NbS$, $Nb_2S_3$, $NbS_2$; molybdenum compounds $Mo_6S_8$, $Mo_2S_3$, $MoS_2$, $MoS_3$; silver compound $Ag_2S$; cadmium compound $CdS$; indium compound $In_2S_3$; tin compounds $SnS$, $SnS_2$; antimony compounds $Sb_2S_3$, $Sb_2S_5$; tantalum compound $TaS_2$; tungsten compound $WS_2$; lead compound $PbS$; bismuth compound $Bi_2S_3$; and mixtures thereof.

8. The method of claim 3, ***characterized in that*** it is carried out in a deposition enclosure in the presence of oxygen in the form of molecular or atomic oxygen, of metal oxide, or of metal oxysulfide present in the target material.

9. The method of one of claims 1 to 8 implemented for the realization of an electrode.

10. The method of any of claims 1 to 9 implemented for the realization of an electrode for battery..

Fig. 1a

Fig. 1b

**Fig. 2a**

**Fig. 2b**

Fig. 3a

Fig. 3b

**Fig. 4a**

**Fig. 4b**

Fig. 5a

Fig. 5b

Fig. 6a

Fig. 6b

**Fig. 7a**

**Fig. 7b**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110076567 A

**Littérature non-brevet citée dans la description**

- **PARK et al.** *Electrochimica Acta,* 2002, vol. 47, 1721-1726

- **JOO et al.** *Electrochemical and solid-state letters,* 2004, vol. 7 (8), A256-A258